(19) Europäisches Patentamt
European Patent Office
Office européen des brevets

(11) **EP 2 892 115 B1**

(12) **FASCICULE DE BREVET EUROPEEN**

(45) Date de publication et mention
de la délivrance du brevet:
**22.08.2018 Bulletin 2018/34**

(51) Int Cl.:
*H01S 5/026* (2006.01)       *H01S 5/065* (2006.01)
*H01S 3/067* (2006.01)       *H01S 5/10* (2006.01)
*H01S 5/40* (2006.01)        *H01S 3/10* (2006.01)
*H01S 5/12* (2006.01)

(21) Numéro de dépôt: **14197354.5**

(22) Date de dépôt: **11.12.2014**

(54) **Source laser a largeur de raie reduite**

Laserquelle mit reduzierter Linienbreite

Laser source with reduced linewidth

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.12.2013 FR 1302929**

(43) Date de publication de la demande:
**08.07.2015 Bulletin 2015/28**

(73) Titulaires:
• **THALES**
**92400 Courbevoie (FR)**
• **Alcatel Lucent**
**91620 Nozay (FR)**
• **COMMISSARIAT À L'ÉNERGIE ATOMIQUE ET
AUX
ÉNERGIES ALTERNATIVES**
**75015 Paris (FR)**

(72) Inventeurs:
• **Duan, Guang-Hua**
**92330 Sceaux (FR)**
• **Van Dijk, Frédéric**
**91120 Palaiseau (FR)**
• **Kervella, Gaël**
**92160 Antony (FR)**

(74) Mandataire: **Henriot, Marie-Pierre**
**Marks & Clerk France**
**Conseils en Propriété Industrielle**
**Immeuble Visium**
**22, Avenue Aristide Briand**
**94117 Arcueil Cedex (FR)**

(56) Documents cités:
WO-A1-00/22705        WO-A1-86/01303
US-A1- 2002 136 258    US-A1- 2012 099 611
US-B1- 6 330 257

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Le domaine de l'invention est celui des sources laser à raies étroites.

La largeur de raie d'un laser est de première importance pour un certain nombre d'applications. On peut citer par exemple, les systèmes de transmission optique cohérents à taux de transmission élevé, pour lesquels une largeur de raie inférieure à 300 kHz est requise lorsqu'utilisés en mode QAM, acronyme de l'expression anglo-saxonne « Quadrature Amplitude Modulation ». Pour générer une onde millimétrique ou téra-hertz en utilisant le battement de deux lasers mono longueur d'onde, la largeur de raie de ces lasers détermine la largeur de raie de l'onde millimétrique ou téra-hertz.

Il existe plusieurs solutions pour réduire la largeur de raie d'une source laser mono longueur d'onde.

La première est bien sûr de concevoir une source laser telle que la largeur de raie est minimisée. Mais il n'est cependant pas toujours possible d'obtenir ainsi la largeur requise.

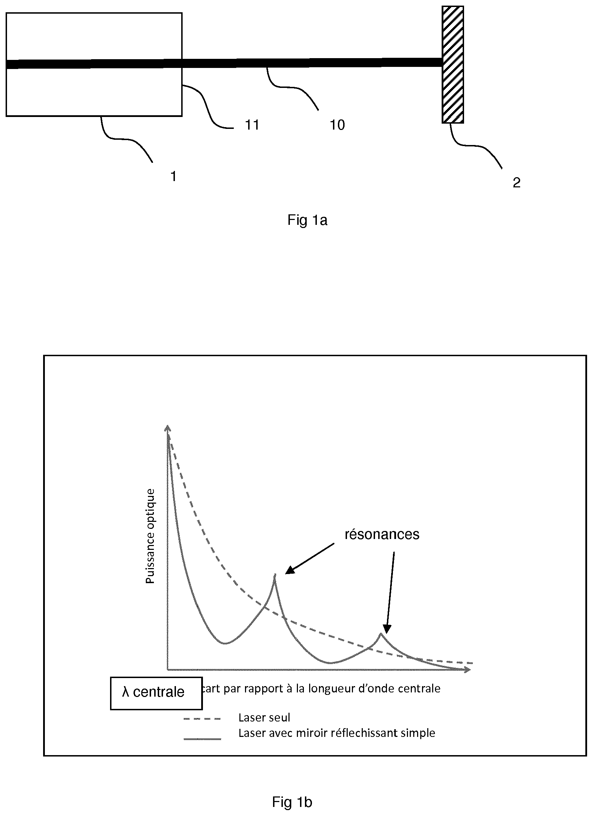

Une autre solution est basée sur une rétroprojection optique externe, telle qu'illustrée figure 1a. La lumière 10 émise par une source laser 1 mono longueur d'onde est réfléchie par un réflecteur externe 2 et réinjectée dans la source laser. Sous certaines conditions de phase, la largeur de raie du laser peut être réduite. Mais le réflecteur externe crée généralement de fortes résonances dans le spectre du bruit de phase et dans le spectre d'émission optique du laser comme illustré figure 1b. Or ces résonances qui correspondent à celles de la cavité externe formée par le miroir externe 2 et la face de sortie 11 de la source laser, ne sont pas souhaitables pour un grand nombre d'applications. Des solutions basées sur la rétroprojection optique externe sont divulguées dans US 2002/0136258 A1 et WO 00/22705. Une troisième solution consiste à utiliser une rétroprojection aléatoire induite par la diffusion de Rayleigh produite dans une fibre optique. La diffusion de Rayleigh est créée en partie par des ions dopants dans une fibre optique monomode. Il a été démontré que la rétroprojection de type Rayleigh peut réduire la largeur de raie d'un facteur $10^6$, pour une longueur d'onde à 1550 nm par exemple. Mais cette rétroprojection de type Rayleigh est très faible. La moyenne de la puissance réfléchie par la diffusion Rayleigh produite dans un tronçon de fibre de 1 km est de l'ordre de $3x10^{-5}$, ce qui impose d'utiliser de très longues fibres optiques, d'une longueur supérieure au moins à 1 km pour permettre d'obtenir une réduction significative de la largeur de raie. Il en résulte que le dispositif laser qui incorpore la source laser et une fibre optique d'une telle longueur, est très encombrant. En outre, les variations de température ou les vibrations induisent des fluctuations dans la diffusion de Rayleigh, qui se traduisent par des fluctuations de la fréquence du laser indésirables.

En outre toutes ces solutions ne s'appliquent qu'à des sources mono longueur d'onde.

En conséquence, il demeure à ce jour un besoin pour un dispositif laser donnant simultanément satisfaction à l'ensemble des exigences précitées, en termes de largeur de raie, d'encombrement, de stabilité en fréquence, et s'appliquant à des sources laser mono ou multi longueurs d'onde.

L'invention est définie par les caractéristiques technique de la revendication 1. Des modes de réalisations préférentiels sont décrits dans les revendications dépendantes.

L'invention est basée sur la création intentionnelle de réflecteurs aléatoirement répartis dans un guide d'onde qui est couplé à une source laser.

Plus précisément l'invention a pour objet un dispositif laser qui comprend une source laser et un guide d'onde d'indice de réfraction déterminé auquel elle est couplée. Il est principalement caractérisé en ce que le guide d'onde est monomode et comporte au moins 4 réflecteurs aléatoirement répartis le long du guide d'onde, la distance séparant deux réflecteurs voisins étant supérieure à 1 $\mu$m, et obtenus par gravure de tranchées dans le guide d'onde résultant en une modification localisée de l'indice de réfraction du guide d'onde, et en ce que le guide d'onde et la source laser ont respectivement des longueurs telles que la longueur de guide d'onde sur laquelle les réflecteurs sont localisés, est supérieure à la longueur de la source laser elle-même.

De tels réflecteurs permettent d'obtenir des réflexions beaucoup plus fortes que celles obtenues par les centres de diffusion de Rayleigh d'une fibre optique. Pour réduire la largeur de raie du laser, on peut alors utiliser des guides d'onde beaucoup plus courts, de quelques centimètres ou moins au lieu de kilomètres de fibres optiques. Le dispositif qui comporte la source et le guide d'onde est donc beaucoup plus compact. En outre, la nature aléatoire de la répartition des réflecteurs permet de réduire la largeur de raie sans créer de résonances prononcées dans le spectre du bruit de phase et dans le spectre d'émission optique du laser. Enfin un tel dispositif permet de réduire la largeur d'une seule raie dans le cas d'une source laser mono longueur d'onde, mais permet également de réduire la largeur de chaque raie d'une source laser multi longueur d'onde.

Selon un premier mode de réalisation de l'invention, la source laser et le guide d'onde forment un ensemble monolithique, et les réflecteurs sont gravés dans le guide d'onde. La source laser est par exemple à semi-conducteur.

Selon un autre mode de réalisation de l'invention, le guide d'onde est couplé à la source laser par un dispositif de couplage, et les réflecteurs sont gravés ou obtenus par insolation du guide d'onde. Le dispositif de couplage est par exemple un connecteur, la source laser et le guide d'onde étant respectivement placés dans deux boîtiers distincts l'un de l'autre ; ou le dispositif de couplage est une lentille, la source laser et le guide d'onde (sous forme de fibre optique lentillée par exemple) étant placés dans un même boîtier.

La longueur du guide d'onde est typiquement inférieure à 100 m quand le guide d'onde est une fibre optique, elle est est typiquement inférieure à 1 cm quand le guide est sur un substrat à semiconducteurs ou sur verre.

D'autres caractéristiques et avantages de l'invention apparaîtront à la lecture de la description détaillée qui suit, faite à titre d'exemple non limitatif et en référence aux dessins annexés dans lesquels :

> la figure 1a représente schématiquement un dispositif laser mono longueur d'onde à réduction de la largeur de raie selon l'état de la technique et les résultats obtenus sont illustrés figure 1b,
> la figure 2 représente schématiquement un exemple de dispositif laser selon un premier mode de réalisation de l'invention,
> les figures 3 représentent schématiquement un exemple de dispositif laser selon un autre mode de réalisation de l'invention, réalisé dans un même boîtier (fig 3a) ou dans deux boîtiers distincts (fig 3b),
> la figure 4 illustre les résultats obtenus avec l'un ou l'autre des modes de réalisation de l'invention pour une source laser mono longueur d'onde.

D'une figure à l'autre, les mêmes éléments sont repérés par les mêmes références.

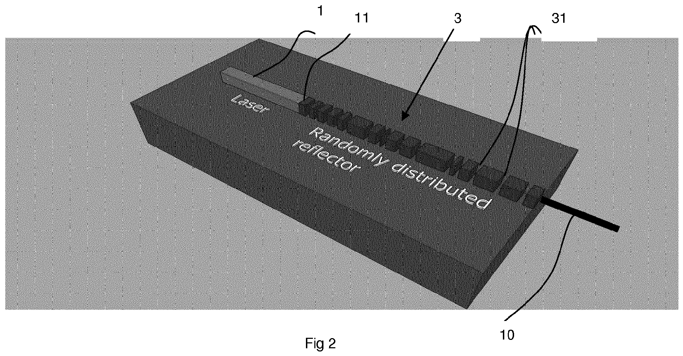

On décrit en relation avec la figure 2, un exemple de premier mode de réalisation d'un dispositif laser selon l'invention.

Une source laser 1 est couplée à un guide d'onde monomode 3 qui est intégré de façon monolithique avec la source laser : ils sont réalisés sur le même matériau de base. Ce couplage entre la source laser et le guide peut se faire suivant plusieurs méthodes parmi lesquelles on peut citer le couplage bout-à-bout, et le couplage par un adaptateur de mode. Des réflecteurs 31 sont gravés dans le guide d'onde sous forme de tranchées aléatoirement réparties le long du guide d'onde. Les tranchées peuvent toutes avoir la même longueur mais pas nécessairement ; la longueur des tranchées (considérée selon le sens de propagation du laser 10) est comprise entre 50 et 500 nm. Le matériau de base est par exemple à base d'InP, GaAs ou est une plateforme d'intégration photonique associant un matériau III-V par exemple à du silicium. Dans ce dernier cas, il s'agit d'une source laser 1 hybride III-V. Les réflecteurs 31 sont gravés dans le guide d'onde 3 de silicium de manière classique, par une méthode de gravure sèche ou humide.

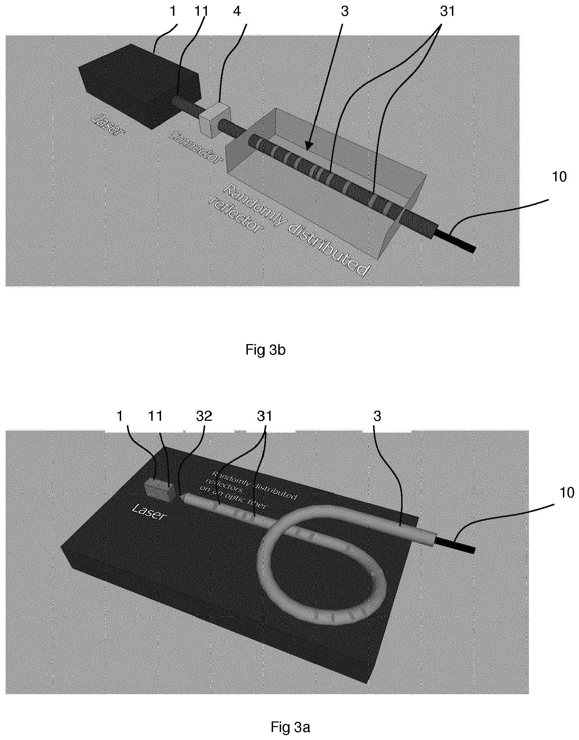

Un exemple de deuxième mode de réalisation d'un dispositif laser selon l'invention est montré figures 3 avec deux variantes. Selon ce mode de réalisation, le guide d'onde 3 est une fibre optique ; la source laser 1 et la fibre optique 3 sont réalisées séparément, puis couplées l'une à l'autre au moyen d'un dispositif de couplage 4. Les réflecteurs 31 sont réalisés dans la fibre optique 3 par exemple par illumination UV à travers un masque de manière à modifier localement l'indice de réfraction de la fibre optique et ainsi obtenir des réflecteurs localisés, comme on le fait pour fabriquer des réseaux de Bragg. Les motifs du masque sont aléatoirement répartis de manière à obtenir une localisation aléatoire des réflecteurs le long de la fibre optique. La source laser peut être un laser à état solide tel qu'un laser à fibre dopé erbium ou un laser à semi-conducteurs.

La source laser et la fibre optique peuvent être intégrées dans un même boîtier ; elles sont alors couplées l'une à l'autre par exemple au moyen d'une lentille 32 comme c'est le cas lorsque la fibre optique 3 est une fibre lentillée comme montré figure 3a. Selon une variante, elles sont fournies dans deux boîtiers distincts ; elles sont alors couplées l'une à l'autre par un connecteur 4 tel qu'un connecteur de fibre optique du type FC/APC, comme montré figure 3b.

La source laser 1 peut être mono longueur d'onde ou multi longueur d'onde, notamment en comportant plusieurs lasers mono longueur d'onde ; elle peut aussi être accordable en longueur d'onde. Le domaine de longueur d'onde se situe typiquement entre 500 nm et 10 $\mu$m. Le guide d'onde est de préférence monomode.

En raison de la nature aléatoire de la localisation des réflecteurs, le niveau de puissance réfléchie totale est la somme des niveaux de puissance créés par tous les réflecteurs. Dit autrement, la réflectivité totale en puissance est la somme des réflectivités en puissance de tous les réflecteurs.

Les réflecteurs 31 peuvent être identiques, c'est-à-dire avoir le même taux de réflexion, mais pas nécessairement. Le taux de réflexion en puissance de chaque réflecteur est compris entre $10^{-5}$ et $10^{-2}$. Ces réflecteurs se distinguent de la rétroprojection de Rayleigh notamment en ce qu'ils sont localisés alors que la rétroprojection de Rayleigh est un phénomène distribué, et qu'un taux de réflexion total raisonnable peut être obtenu selon l'invention avec l'ensemble de réflecteurs sur une longueur très courte :

- inférieure à 100 m dans une fibre optique, avec alors un taux de réflexion total > $10^{-3}$ par exemple,
- typiquement inférieure à 1 cm dans un guide d'onde monolithiquement intégré, avec alors un taux de réflexion total > $10^{-1}$ par exemple,

alors que dans le cas de la rétroprojection de Rayleigh le même taux de réflexion total ne peut pas être obtenu même avec une fibre de plusieurs dizaines de km.

Selon un autre mode de réalisation, la source laser est couplée à un guide d'onde monomode qui est gravé dans du verre. Les réflecteurs sont obtenus sous forme de tranchées gravées dans le guide d'onde et bien sûr aléatoirement réparties.

Le facteur de réduction de la largeur de raie est le rapport entre la largeur de raie initiale de la source laser, et celle du dispositif laser muni de ses réflecteurs aléatoires. La demanderesse a montré que le facteur de réduction dépend :

- de la réflectivité totale en puissance,
- du temps de trajet aller-retour de la lumière entre la face de sortie 11 de la source laser et le réflecteur le plus éloigné, et
- du temps de trajet aller-retour de la lumière à l'intérieur de la cavité de la source laser elle-même.

On utilisera typiquement dans cette invention :

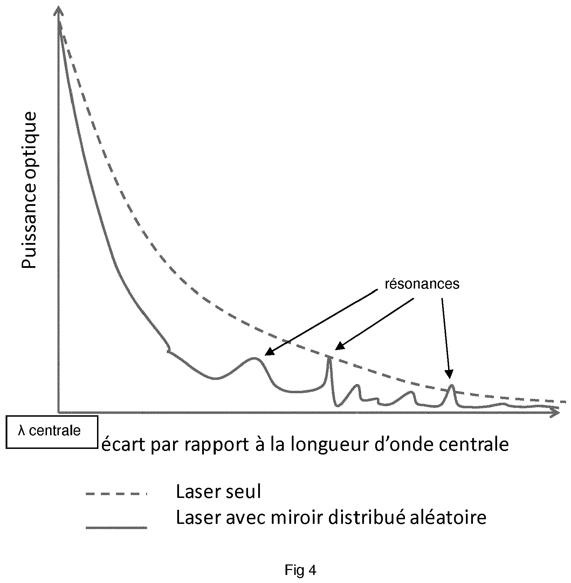

- une réflectivité totale en puissance ≥ 0,1 %,
- une longueur de guide d'onde (ou de fibre optique) sur lequel les réflecteurs sont localisés, supérieure à la longueur de la source laser elle-même, ces longueurs étant mesurées selon l'axe de propagation du laser 10,
- un nombre de réflecteurs compris entre 4 et 1000 par millimètre dans le cas du guide d'onde monolithiquement intégré, entre 4 et 10000 par millimètre dans le cas de fibre optique. Les résultats obtenus sont illustrés figure 4 : outre la réduction de la largeur de la raie, on remarque aussi que les résonances visibles sur la figure 1b sont beaucoup moins prononcées, et réparties de façon aléatoire.

La position aléatoire des réflecteurs est obtenue en plaçant les réflecteurs de façon irrégulière le long du guide d'onde. Dit autrement la distance entre réflecteurs voisins est irrégulière.

Des simulations ont été réalisées en utilisant le logiciel Matlab pour calculer la répartition aléatoire des réflecteurs le long du guide d'onde, en utilisant 100, 500 ou 1000 réflecteurs. Il génère une variable aléatoire x comprise entre 0 et 1. La position du kième réflecteur est donnée par :

$$L(k)=Li + (Lf-Li) \, x,$$

où Li est la longueur entre la face de sortie de la source laser et la position du réflecteur le plus proche de cette face, et Lf la longueur entre la face de sortie de la source laser et la position du réflecteur le plus éloigné de cette face.

La position aléatoire des réflecteurs peut bien sûr être obtenue de façon manuelle.

Selon l'invention deux réflecteurs voisins sont typiquement séparés l'un de l'autre d'une distance supérieure à 1 $\mu$m. Alors que dans le cas de la diffusion de Rayleigh, les réflecteurs créés par des ions dopants sont donc séparés d'une distance de l'ordre du nm.

A titre d'exemple, on peut dire qu'avec une réflectivité totale en puissance ≥ 1% obtenue avec environ 1000 réflecteurs, et une longueur de guide d'onde 10 fois supérieure à celle de la source laser soit 10 mm par exemple, on prévoit un facteur de réduction de 50 pour la raie de longueur d'onde centrale λ= 1550 nm d'une source laser semiconducteur d'une longueur de 1 mm.

**Revendications**

1. Dispositif laser qui comprend une source laser (1) et un guide d'onde (3) d'indice de réfraction déterminé auquel elle est couplée, le guide d'onde étant monomode et comportant au moins 4 réflecteurs (31), la distance séparant deux réflecteurs voisins étant supérieure à 1 $\mu$m, le taux de réflexion en puissance de chaque réflecteur (31) étant compris entre $10^{-5}$ et $10^{-2}$, **caractérisé en ce que** lesdits réflecteurs (31) sont réalisés sous forme de tranchées gravées dans le guide d'onde, chaque réflecteur correspondant à une desdites tranchées, et répartis de manière irrégulière le long du guide d'onde (3), et **en ce que** le guide d'onde et la source laser ont respectivement des longueurs telles que la longueur de guide d'onde sur laquelle les réflecteurs sont localisés, est supérieure à la longueur de la source laser elle-même.

2. Dispositif laser selon la revendication précédente, **caractérisé en ce que** la source laser (1) et le guide d'onde (3) forment un ensemble monolithique, et **en ce que** les réflecteurs (31) sont gravés dans le guide d'onde.

3. Dispositif laser selon la revendication précédente, **caractérisé en ce que** la source laser (1) est à semiconducteur.

4. Dispositif laser selon la revendication 1, **caractérisé en ce que** le guide d'onde (3) est couplé à la source laser (1) par un dispositif de couplage, et **en ce que** les réflecteurs sont gravés ou obtenus par insolation du guide d'onde.

5. Dispositif laser selon la revendication précédente, **caractérisé en ce que** le dispositif de couplage est un connecteur (4), la source laser et le guide d'onde étant respectivement placés dans deux boîtiers distincts l'un de l'autre.

6. Dispositif laser selon la revendication 4, **caractérisé en ce que** le dispositif de couplage est une lentille (32), la source laser et le guide d'onde étant placés dans un même boîtier.

7. Dispositif laser selon l'une des revendications précédentes, **caractérisé en ce que** la longueur du guide d'onde (3) est inférieure à 100 m.

8. Dispositif laser selon l'une des revendications précédentes, **caractérisé en ce que** la source laser est mono longueur d'onde ou multi longueur d'onde ou accordable en longueur d'onde.

9. Dispositif laser selon l'une des revendications précédentes, **caractérisé en ce que** la source laser comporte plusieurs lasers mono longueur d'onde.

10. Dispositif laser selon l'une des revendications précédentes, **caractérisé en ce que** la source laser est à état solide.

**Patentansprüche**

1. Laservorrichtung, die eine Laserquelle (1) und einen Wellenleiter (3) mit einem bestimmten Brechungsindex umfasst, mit dem er gekoppelt ist, wobei der Wellenleiter monomodal ist und wenigstens 4 Reflektoren (31) umfasst, wobei die zwei benachbarte Reflektoren trennende Distanz größer als 1 $\mu$m ist, wobei die Leistungsreflexionsrate jedes Reflektors (31) zwischen $10^{-5}$ und $10^{-2}$ liegt, **dadurch gekennzeichnet, dass** die Reflektoren (31) in Form von in den Wellenleiter geätzten Gräben realisiert, wobei jeder Reflektor einem der Gräben entspricht, und auf unregelmäßige Weise entlang dem Wellenleiter (3) verteilt sind, und dadurch, dass der Wellenleiter und die Laserquelle jeweils solche Längen haben, dass die Länge des Wellenleiters, auf dem sich die Reflektoren befinden, größer ist als die Länge der Laserquelle selbst.

2. Laservorrichtung nach dem vorherigen Anspruch, **dadurch gekennzeichnet, dass** die Laserquelle (1) und der Wellenleiter (3) eine monolithische Baugruppe bilden, und dadurch, dass die Reflektoren (31) in den Wellenleiter geätzt sind.

3. Laservorrichtung nach dem vorherigen Anspruch, **dadurch gekennzeichnet, dass** die Laserquelle (1) eine Halbleiterlaserquelle ist.

4. Laservorrichtung nach Anspruch 1, **dadurch gekennzeichnet, dass** der Wellenleiter (3) durch eine Kopplungsvorrichtung mit der Laserquelle (1) gekoppelt ist, und dadurch, dass die Reflektoren durch Bestrahlung des Wellenleiters geätzt oder erhalten werden.

5. Laservorrichtung nach dem vorherigen Anspruch, **dadurch gekennzeichnet, dass** die Kopplungsvorrichtung ein Verbinder (4) ist, wobei die Laserquelle und der Wellenleiter jeweils in zwei voneinander getrennten Gehäusen platziert sind.

6. Laservorrichtung nach Anspruch 4, **dadurch gekennzeichnet, dass** die Kopplungsvorrichtung eine Linse (32) ist, wobei die Laserquelle und der Wellenleiter im selben Gehäuse platziert sind.

7. Laservorrichtung nach einem der vorherigen Ansprüche, **dadurch gekennzeichnet, dass** die Länge des Wellenleiters (3) kleiner als 100 m ist.

8. Laservorrichtung nach einem der vorherigen Ansprüche, **dadurch gekennzeichnet, dass** die Laserquelle eine Monowellenlängen- oder eine Multiwellenlängenlaserquelle oder wellenlängenabstimmbar ist.

9. Laservorrichtung nach einem der vorherigen Ansprüche, **dadurch gekennzeichnet, dass** die Laserquelle mehrere Monowellenlängenlaser umfasst.

10. Laservorrichtung nach einem der vorherigen Ansprüche, **dadurch gekennzeichnet, dass** die Laserquelle im festen Zustand ist.

**Claims**

1. Laser device which comprises a laser source (1) and a waveguide (3) which has a predetermined refractive index and to which it is coupled, the waveguide being single-mode and comprising at least four reflectors (31), the distance separating two neighbouring reflectors being greater than 1 $\mu$m, the degree of power reflection of each reflector (31) being between $10^{-5}$ and $10^{-2}$, **characterised in that** the reflectors (31) are produced in the form of channels etched into the waveguide, each reflector corresponding to one of the channels, and distributed in an irregular manner along the waveguide (3), and **in that** the waveguide and the laser source have respective lengths such that the length of waveguide over which the reflectors are located is greater than the length of the laser source itself.

2. Laser device according to the preceding claim, **characterised in that** the laser source (1) and the waveguide (3) form a monolithic assembly, and **in that** the reflectors (31) are etched into the waveguide.

3. Laser device according to the preceding claim, **characterised in that** the laser source (1) is semiconductor-based.

4. Laser device according to claim 1, **characterised in that** the waveguide (3) is coupled to the laser source (1) by way of a coupling device, and **in that** the reflectors are etched or obtained by solar irradiation of the waveguide.

5. Laser device according to the preceding claim, **characterised in that** the coupling device is a connector (4), the laser source and the waveguide being placed in two mutually separate housings, respectively.

6. Laser device according to claim 4, **characterised in**

**EP 2 892 115 B1**

**that** the coupling device is a lens (32), the laser source and the waveguide being placed in one and the same housing.

7. Laser device according to any one of the preceding claims, **characterised in that** the length of the waveguide (3) is less than 100 m.

8. Laser device according to any one of the preceding claims, **characterised in that** the laser source is single-wavelength or multi-wavelength or tunable in terms of wavelength.

9. Laser device according to any one of the preceding claims, **characterised in that** the laser source comprises a plurality of single-wavelength lasers.

10. Laser device according to any one of the preceding claims, **characterised in that** the laser source is solid-state.

Fig 1a

Puissance optique

résonances

λ centrale

écart par rapport à la longueur d'onde centrale

— — — Laser seul

Laser avec miroir réflechissant simple

Fig 1b

Fig 2

résonances

Puissance optique

λ centrale

écart par rapport à la longueur d'onde centrale

- - - - Laser seul

_____ Laser avec miroir distribué aléatoire

Fig 4

Fig 3b

Fig 3a

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20020136258 A1
- WO 0022705 A